# FASCICULE DE BREVET EUROPEEN

(11) **EP 4 734 739 B1**
(45) Date de publication et mention de la délivrance du brevet: **25.11.2026**
(21) Numéro de dépôt: 25206583.4
(22) Date de dépôt: 03.10.2025
(51) Int. Cl.: H10W 40/00, H05K 1/02, H05K 1/181, H05K 1/185, H10W 74/10

(54) **ENSEMBLE COMPRENANT UN MODULE DE PUISSANCE, UN CAPTEUR DE TEMPÉRATURE ET UNE CARTE DE CIRCUIT IMPRIMÉ**
ANORDNUNG MIT EINEM LEISTUNGSMODUL, EINEM TEMPERATURSENSOR UND EINER LEITERPLATTE
ASSEMBLY COMPRISING A POWER MODULE, A TEMPERATURE SENSOR AND A CIRCUIT BOARD

(30) Priorité: 23.10.2024 FR 2411586
(43) Date de publication de la demande: 29.04.2026
(73) Titulaire: Valeo Electrification, 95892 Cergy Pontoise (FR)
(72) Inventeur: POUILLY, Aurélien, 95892 Cergy Pontoise (FR); YVON, Sylvain, 95892 Cergy Pontoise (FR); MERCIER, Philippe, 72300 Sablé Sur Sarthe (FR)
(74) Mandataire: Valeo Powertrain Systems

(56) Documents cités:
- EP-A1- 4 403 893
- CN-A- 110 707 062
- DE-A1- 102013 213 448
- DE-A1- 102022 113 639
- US-A1- 2023 048 878

## Description

La présente invention se rapporte au domaine des systèmes électroniques comprenant au moins un module de puissance relié à une carte de circuit imprimé.

Un module de puissance dans l'industrie automobile est un ensemble compact et intégré de composants électroniques qui gère et convertit les courants électriques de haute puissance, essentiels au fonctionnement des véhicules électriques et hybrides.

Plus précisément, l'invention trouve un intérêt particulier dans le domaine des chargeurs embarqués et des onduleurs pour véhicule électrique ou hybrides.

Les chargeurs embarqués et les onduleurs comprennent divers composants électroniques, notamment des modules de puissance. Ces modules de puissance sont généralement réalisés sous la forme d'un boîtier, notamment en époxy, qui intègre plusieurs composants, notamment des composants de commutation et/ou de conversion de puissance électrique qui sont en matériau semi-conducteurs (Si, SiC, GAN, etc...) que l'on désignera plus généralement par le terme de puces électroniques.

Les véhicules électriques nécessitent des puissances de charge toujours plus élevées afin de réduire les temps de charge. L'augmentation de ces puissances de charge s'accompagne d'une production de chaleur de plus en plus importante lors du fonctionnement des chargeurs embarqués et ces modules de puissance sont parmi les composants électroniques générant le plus de chaleur.

Afin de construire les lois de contrôle des chargeurs embarqués, la température des puces électroniques est une donnée cruciale à connaître instantanément.

Grâce à cette donnée sur la température, le chargeur embarqué peut activer une stratégie de régulation afin de protéger la puce électronique avant qu'elle n'atteigne une température critique pouvant l'endommager.

Il existe des modules de puissance qui intègrent directement à l'intérieur du boîtier un capteur de température (voir, par exemple, US 2023/048878 A1), notamment une thermistance à coefficient de température négatif. Ce capteur de température est généralement éloigné de la puce électronique, ce qui signifie que la mesure n'est pas assez précise.

De plus, certains modules de puissance n'intègrent pas de tels capteurs de températures. Ces modules de puissance ont l'avantage d'être relativement peu coûteux en comparaison des modules de puissance intégrant un capteur de température mais ne permettent pas de mesurer la température à proximité des puces électroniques.

Il est donc nécessaire de proposer un moyen efficace pour mesurer la température des puces électroniques des modules de puissance n'intégrant pas de capteur de températures à l'intérieur du boîtier.

Ainsi l'invention propose un ensemble comprenant un module de puissance, un capteur de température et une carte à circuit imprimé, le module de puissance comprend un boîtier intégrant au moins une puce électronique disposée sur un substrat, le boîtier comprend une face inferieure tournée vers la carte à circuit imprimé et une face supérieure, la carte à circuit imprimé comprend une face supérieure sur laquelle est disposé le module de puissance et une face inferieure. Selon l'invention le capteur de température est agencé au droit du module de puissance entre la face inferieure du module de puissance et la face inferieure de la carte à circuit imprimé.

Cet agencement permet une mesure directe de la température des puces électroniques sans impacter le volume du module de puissance. Cela permet également de rendre cet agencement compatible avec la tendance de réduction de taille dans le domaine des chargeurs embarqués de véhicules.

Le terme « au droit de » signifie que le capteur de température se situe sous le module de puissance dans un espace défini par une projection du contour du boîtier sur la carte à circuit imprimé.

Selon l'invention, au moins deux broches de connexion électrique sont issues du boîtier du module de puissance. Ces broches de connexion électrique sont au contact de pistes conductrices disposées sur la carte à circuit imprimé. Ces broches de connexion électrique sont également en liaison électrique avec la ou les puces électroniques qui se trouvent dans le boîtier du module de puissance. Le boîtier est de préférence réalisé en époxy.

Selon un premier mode de réalisation de l'invention, le capteur de température comprend un boîtier comprenant une face inferieure tournée vers la carte à circuit imprimé et une face supérieure tournée vers le module de puissance. Au moins deux broches de connexion électrique sont issues du boîtier du capteur de température. Ces broches de connexion électrique sont au contact de pistes conductrices disposées sur la carte à circuit imprimé. Ces broches de connexion électrique sont également en liaison électrique avec au moins un élément sensible à la température se trouvant dans le boîtier du capteur de température.

Selon une caractéristique de l'invention, une cavité est ménagée au niveau de la face inferieure du module de puissance. De manière avantageuse, le capteur de température est ménagé en partie dans cette cavité. Grâce à cet agencement, la face inferieure du module de puissance et la face inferieure du capteur de température se trouvent sensiblement dans un même plan ce qui rend l'ensemble plus compact. La cavité est obtenue par enlèvement de matière de la face inferieure du module de puissance, par exemple par usinage ou ablation laser. De manière alternative, la cavité peut être obtenue directement lors du moulage du boîtier du module de puissance. La cavité est ouverte en direction de la carte à circuit imprimé. De manière avantageuse, la cavité présente une forme sensiblement complémentaire à la forme externe du boîtier du capteur de température. Le fond de la cavité définit la face inferieure du module de puissance.

Selon une caractéristique additionnelle de l'invention, un matériau d'interface thermique est disposé entre le module de puissance et le capteur de température permettant de garantir un contact thermique entre le module de puissance et le capteur de température. Ce matériau est disposé dans un espace laissé libre entre le module de puissance et le capteur de température. L'effet technique de ce matériau d'interface thermique est d'éliminer les poches d'air qui pourraient créer une résistance thermique supplémentaire, assurant ainsi un transfert thermique optimal et une mesure de température représentative de l'état thermique réel des puces électroniques.

Selon un deuxième mode de réalisation de l'invention, le capteur de température est intégré dans la carte à circuit imprimé entre la face supérieure sur laquelle est disposée le module de puissance et la face inferieure. Par rapport au premier mode de réalisation, ce deuxième mode de réalisation à l'avantage de ne pas creuser de cavité dans le boîtier du module de puissance. Il n'y a ainsi pas d'impact dimensionnel du module de puissance pour l'intégration d'une mesure de température.

Selon l'invention, la carte électronique est multicouche intégrant une pluralité de pistes conductrices intermédiaires disposées entre la face supérieure et la face inferieure de la carte électronique. De manière avantageuse, le capteur de température est en contact électrique avec l'une des pistes conductrices de la carte électronique, notamment l'une des pistes conductrices intermédiaires. Dans ce cas il faut prévoir une liaison thermique avec la face supérieure de la carte électronique, par exemple via des borgnes métallisés.

Selon l'invention, un matériau d'interface thermique est disposé entre le module de puissance et la face supérieure de la carte électronique permettant de garantir un contact thermique entre le module de puissance et la face supérieure de la carte électronique. La mesure de la température est ainsi précise car les comportements thermiques du matériau d'interface thermique et du matériau du boîtier du module de puissance sont bien connus. Ce matériau est disposé dans un espace laissé libre entre le module de puissance et la face supérieure de la carte électronique.

Selon l'invention, l'ensemble comprend en outre un élément dissipateur de chaleur et la face supérieure du module de puissance est au contact de l'élément dissipateur de chaleur. La face supérieure du module de puissance assure ainsi le refroidissement de l'ensemble. Cette architecture est connue sous le terme anglais « *top side cooling ».* La face supérieure du module de puissance est au contact de l'élément dissipateur de chaleur de manière directe ou indirecte via un matériau d'interface thermique.

Selon l'invention, le substrat se trouve entre la puce électronique et le capteur de température. Cette caractéristique permet de préserver l'intégrité structurelle du module de puissance tout en assurant une mesure de température précise grâce à la conductivité thermique élevée du substrat.

L'invention porte également sur un dispositif de chargeur embarqué ou un onduleur pour véhicule automobile, notamment électrique ou hybride comprenant un ensemble selon au moins l'une des caractéristiques précitées. L'effet technique global de l'invention dans ces applications est l'amélioration de la fiabilité et de la durée de vie des composants de puissance grâce à une surveillance thermique précise permettant l'activation de stratégies de protection thermique avant l'atteinte de températures critiques.

D'autres caractéristiques et avantages de l'invention ressortiront à la lecture qui suit de deux exemples de réalisations détaillés, en référence aux figures annexées :
la [Figure 1] représente une vue d'un ensemble selon l'invention et selon un premier mode de réalisation ;
la [Figure 2] représente une vue d'un ensemble selon l'invention et selon un deuxième mode de réalisation.

Il est à noter que les figures divulguent l'invention d'une manière suffisamment détaillée pour sa mise en œuvre, lesdites figures aidant à mieux définir l'invention au besoin.

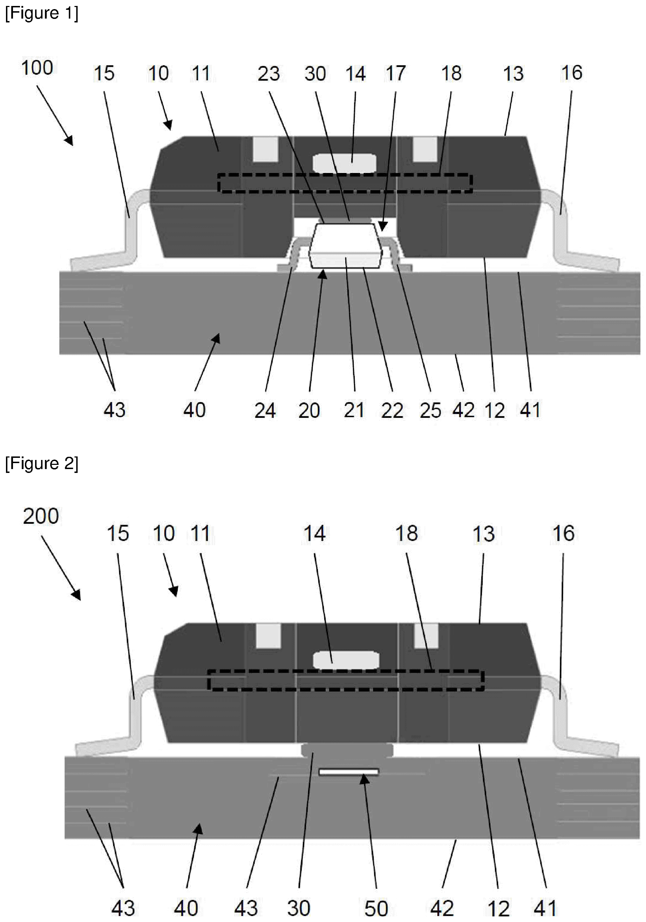

La [Figure 1] montre un ensemble 100 selon un premier mode de réalisation. Cet ensemble 100 comprend un module de puissance 10, un capteur de température 20 et une carte à circuit imprimé 40.

Le module de puissance 10 permet de compiler une pluralité de puces électroniques 14 dans un espace réduit. Plus précisément, le module de puissance 10 comprend un boîtier 11 au sein duquel sont disposées côte à côte des puces électroniques 14 sur un substrat 18.
Ces puces électroniques 14 sont typiquement des composants de commutation et/ou de conversion de puissance électrique réalisés en matériaux semi-conducteurs tels que le silicium (Si), le carbure de silicium (SiC) ou le nitrure de gallium (GaN). Ces matériaux présentent des propriétés thermiques spécifiques, notamment une conductivité thermique élevée pour le SiC comparé au silicium, ce qui influence directement la dissipation thermique et la nécessité d'une mesure de température précise. Le module de puissance 10 présente une forme rectangulaire, définie par la forme rectangulaire du boîtier 11. En d'autres termes, le module de puissance comprend deux bords en opposition qui présentent chacun une dimension d'allongement plus importante que celle des deux autres bords. Cette géométrie rectangulaire est optimisée pour maximiser la surface de dissipation thermique tout en minimisant l'encombrement. Bien entendu, le boîtier du module de puissance peut présenter d'autres formes géométriques, par exemple de forme carrée.

Le boîtier 11 comprend une face inferieure 12 tournée vers la carte à circuit imprimé 40 et une face supérieure 13 opposée à la face inferieure 12. La face supérieure 13 est de préférence au contact d'un élément dissipateur de chaleur (non représenté) afin de refroidir l'ensemble 100. Cette configuration correspond à une architecture de refroidissement par le dessus qui permet d'évacuer efficacement la chaleur générée par les puces électroniques 14 vers l'élément dissipateur. Le flux thermique principal s'établit donc depuis les puces électroniques 14, à travers le substrat 18 et le boîtier 11, vers la face supérieure 13.

La carte à circuit imprimé 40 comprend une face supérieure 41 sur laquelle est disposé le module de puissance 10 et une face inferieure 42 opposée à la face supérieure 41.

Les puces électroniques 14 sont disposées sur un substrat 18 commun. Les puces électroniques 14 sont connectées à des broches de connexion électrique 15, 16 qui s'étendent à l'extérieur du module de puissance 10, notamment pour permettre le raccordement électrique des puces électroniques 14, logées à l'intérieur du boîtier 11, à un réseau électrique via la carte à circuit imprimé 40. Les broches de connexion électrique 15, 16 sont au contact de pistes conductrices disposées sur la carte à circuit imprimé 40. Les broches de connexion électrique 15, 16 font saillie du boîtier 11 sur l'un ou les deux bords présentant la dimension d'allongement la plus importante.
Le capteur de température 20 est agencé au droit du module de puissance 10 entre la face inferieure 12 du module de puissance 10 et la face inferieure 42 de la carte à circuit imprimé 40.

Le capteur de température 20 comprend un boîtier 21 comprenant une face inferieure 22 tournée vers la carte à circuit imprimé 40 et une face supérieure 23 tournée vers le module de puissance 10. Le capteur de température 20 peut être une thermistance à coefficient de température négatif (CTN) ou une résistance à coefficient de température positif (CTP).

Des broches de connexion électrique 24, 25 sont issues du boîtier 21 du capteur de température 20. Ces broches de connexion électrique 24, 25 sont au contact de pistes conductrices disposées sur la face supérieure 41 de la carte à circuit imprimé 40 permettant ainsi la transmission du signal de mesure vers les circuits de traitement.

Une cavité 17 est ménagée au niveau de la face inferieure 12 du module de puissance 10. Le capteur de température 20 est ménagé en partie dans cette cavité 17. La profondeur de la cavité 17 est dimensionnée pour recevoir au moins partiellement le boîtier 21 du capteur de température 20, permettant ainsi de réduire l'épaisseur totale de l'ensemble et d'améliorer le couplage thermique. La forme de la cavité 17 est de préférence complémentaire à celle du boîtier 21 du capteur de température 20 pour optimiser le contact thermique.

La cavité 17 est obtenue par enlèvement de matière de la face inferieure 12 du module de puissance 10, notamment par ablation laser. Cette technique d'ablation laser permet un usinage précis et contrôlé du matériau époxy du boîtier 11 sans endommager les composants internes. L'ablation laser présente l'avantage de créer des surfaces lisses et de permettre un contrôle dimensionnel précis de la cavité 17. Alternativement, la cavité 17 peut être réalisée par usinage mécanique ou être directement intégrée lors du processus de moulage du boîtier 11.

Un matériau d'interface thermique 30 est disposé entre le module de puissance 10 et le capteur de température 20. Ce matériau d'interface thermique 30 peut être une pâte thermique, un pad thermique ou un matériau à changement de phase, présentant une conductivité thermique élevée pour assurer un transfert thermique optimal. Le matériau d'interface thermique 30 compense les irrégularités de surface et élimine les poches d'air qui constitueraient des résistances thermiques parasites.

La [Figure 2] montre un ensemble 200 selon un deuxième mode de réalisation. A la différence du premier mode de réalisation, cet ensemble 200 comprend un capteur de température 50 qui est intégré dans la carte à circuit imprimé 40 entre la face supérieure 41 sur laquelle est disposé le module de puissance 10 et la face inferieure 42. Cette configuration présente l'avantage de ne pas nécessiter de modification du module de puissance 10, préservant ainsi la garantie du fournisseur et l'intégrité mécanique du boîtier 11.A cet effet, la carte électronique 40 est multicouche intégrant une pluralité de pistes conductrices intermédiaires 43 disposées entre la face supérieure 41 et la face inferieure 42 de la carte électronique 40. Cette structure multicouche, typiquement composée de 4 à 8 couches, permet d'intégrer le capteur de température 50 dans une couche intermédiaire tout en maintenant les fonctionnalités électriques de la carte électronique 40.

Le capteur de température 50 est de préférence en contact avec l'une des pistes conductrices intermédiaires. Une liaison thermique avec la face supérieure de la carte électronique 40, par exemple via des borgnes métallisés peut être prévue.

Un matériau d'interface thermique 30 est disposé entre le module de puissance 10 et la face supérieure 41 de la carte électronique 40.

Une des caractéristiques communes aux deux modes de réalisation est que le substrat 18 se trouve entre la ou les puces électroniques 14 et le capteur de température 20, 50.

Les deux modes de réalisation permettent d'obtenir une mesure de température représentative de l'état thermique des puces électroniques 14 avec une constante de temps réduite par rapport aux solutions de l'art antérieur.

Dans les revendications, les symboles de référence entre parenthèses ne doivent pas être interprétés comme une limitation de la revendication.

## Revendications

1. Ensemble (100, 200) comprenant un module de puissance (10), un capteur de température (20, 50) et une carte à circuit imprimé (40), le module de puissance (10) comprend un boîtier (11) intégrant au moins une puce électronique (14) disposée sur un substrat (18), le boîtier (11) comprend une face inferieure (12) tournée vers la carte à circuit imprimé (40) et une face supérieure (13), la carte à circuit imprimé (40) comprend une face supérieure (41) sur laquelle est disposé le module de puissance (10) et une face inferieure (42), **caractérisé en ce que** le capteur de température (20, 50) est agencé au droit du module de puissance (10) entre la face inferieure (12) du module de puissance (10) et la face inferieure (42) de la carte à circuit imprimé (40) et **en ce que** le substrat (18) se trouve entre la puce électronique (14) et le capteur de température (20, 50).

2. Ensemble (100, 200) selon la revendication 1, **caractérisé en ce que** au moins deux broches de connexion électrique (15, 16) sont issues du boîtier (11) du module de puissance (10), ces broches de connexion électrique (15, 16) étant au contact de pistes conductrices disposées sur la carte à circuit imprimé (40).

3. Ensemble (100) selon la revendication 1 ou 2, **caractérisé en ce que** le capteur de température (20) comprend un boîtier (21) comprenant une face inferieure (22) tournée vers la carte à circuit imprimé (40) et une face supérieure (23) tournée vers le module de puissance (10), au moins deux broches de connexion électrique (24, 25) sont issues du boîtier (21) du capteur de température (20), ces broches de connexion électrique (24, 25) étant au contact de pistes conductrices disposées sur la carte à circuit imprimé (40).

4. Ensemble (100) selon l'une des revendications précédentes, **caractérisé en ce qu'**une cavité (17) est ménagée au niveau de la face inferieure (12) du module de puissance (10), ledit capteur de température (20) est ménagé en partie dans cette cavité (17).

5. Ensemble (100) selon la revendication 4, **caractérisé en ce qu'**un matériau d'interface thermique (30) est disposé entre le module de puissance (10) et le capteur de température (20).

6. Ensemble (200) selon la revendication 1 ou 2, **caractérisé en ce que** le capteur de température (50) est intégré dans la carte à circuit imprimé (40) entre la face supérieure (41) sur laquelle est disposée le module de puissance (10) et la face inferieure (42).

7. Ensemble (200) selon la revendication 6, **caractérisé en ce que** la carte électronique (40) est multicouche intégrant une pluralité de pistes conductrices intermédiaires (43) disposées entre la face supérieure (41) et la face inferieure (42) de la carte électronique (40).

8. Ensemble (100, 200) selon la revendication 6 ou 7, **caractérisé en ce qu'**un matériau d'interface thermique (30) est disposé entre le module de puissance (10) et la face supérieure (41) de la carte électronique (40).

9. Ensemble (100, 200) selon l'une des revendications précédentes, **caractérisé en ce qu'**il comprend en outre un élément dissipateur de chaleur, la face supérieure (13) du module de puissance (10) étant au contact de l'élément dissipateur de chaleur.

10. Dispositif de chargeur embarqué ou onduleur pour véhicule automobile comprenant un ensemble (100, 200) selon au moins l'une des revendications précédentes.

## Patentansprüche

1. Anordnung (100, 200), umfassend ein Leistungsmodul (10), einen Temperatursensor (20, 50) und eine Leiterplatte (40), wobei das Leistungsmodul (10) ein Gehäuse (11) umfasst, in das mindestens ein auf einem Substrat (18) angeordneter elektronischer Chip (14) integriert ist, wobei das Gehäuse (11) eine der Leiterplatte (40) zugewandte Unterseite (12) und eine Oberseite (13) aufweist, die Leiterplatte (40) umfasst eine Oberseite (41), auf der das Leistungsmodul (10) angeordnet ist, sowie eine Unterseite (42), **dadurch gekennzeichnet, dass** der Temperatursensor (20, 50) in Deckung mit dem Leistungsmodul (10) zwischen der Unterseite (12) des Leistungsmoduls (10) und der Unterseite (42) der Leiterplatte (40) angeordnet ist und dass sich das Substrat (18) zwischen dem elektronischen Chip (14) und dem Temperatursensor (20, 50) befindet.

2. Anordnung (100, 200) nach Anspruch 1, **dadurch gekennzeichnet, dass** mindestens zwei elektrische Anschlussstifte (15, 16) aus dem Gehäuse (11) des Leistungsmoduls (10) herausragen, wobei diese elektrischen Anschlussstifte (15, 16) mit auf der Leiterplatte (40) angeordneten Leiterbahnen in Kontakt stehen.

3. Anordnung (100) nach Anspruch 1 oder 2, **dadurch gekennzeichnet, dass** der Temperatursensor (20) ein Gehäuse (21) umfasst, das eine der Leiterplatte (40) zugewandte Unterseite (22) und eine dem Leistungsmodul (10) zugewandte Oberseite (23) aufweist, wobei mindestens zwei elektrische Anschlussstifte (24, 25) aus dem Gehäuse (21) des Temperatursensors (20) herausragen, wobei diese elektrischen Anschlussstifte (24, 25) mit auf der Leiterplatte (40) angeordneten Leiterbahnen in Kontakt stehen.

4. Anordnung (100) nach einem der vorstehenden Ansprüche, **dadurch gekennzeichnet, dass** an der Unterseite (12) des Leistungsmoduls (10) eine Aussparung (17) ausgebildet ist, wobei der Temperatursensor (20) teilweise in dieser Aussparung (17) untergebracht ist.

5. Anordnung (100) nach Anspruch 4, **dadurch gekennzeichnet, dass** zwischen dem Leistungsmodul (10) und dem Temperatursensor (20) ein Wärmeleitmaterial (30) angeordnet ist.

6. Anordnung (200) nach Anspruch 1 oder 2, **dadurch gekennzeichnet, dass** der Temperatursensor (50) in die Leiterplatte (40) zwischen der Oberseite (41), auf der das Leistungsmodul (10) angeordnet ist, und der Unterseite (42) integriert ist.

7. Anordnung (200) nach Anspruch 6, **dadurch gekennzeichnet, dass** die Leiterplatte (40) mehrschichtig ist und eine Vielzahl von Zwischenleiterbahnen (43) aufweist, die zwischen der Oberseite (41) und der Unterseite (42) der Leiterplatte (40) angeordnet sind.

8. Anordnung (100, 200) nach Anspruch 6 oder 7, **dadurch gekennzeichnet, dass** ein Wärmeleitmaterial (30) zwischen dem Leistungsmodul (10) und der Oberseite (41) der Leiterplatte (40) angeordnet ist.

9. Anordnung (100, 200) nach einem der vorstehenden Ansprüche, **dadurch gekennzeichnet, dass** sie ferner ein Wärmeableitungselement umfasst, wobei die Oberseite (13) des Leistungsmoduls (10) mit dem Wärmeableitungselement in Kontakt steht.

10. Bordladegerät oder Wechselrichter für ein Kraftfahrzeug, umfassend eine Anordnung (100, 200) gemäß mindestens einem der vorstehenden Ansprüche.

## Claims

1. Assembly (100, 200) comprising a power module (10), a temperature sensor (20, 50) and a printed circuit board (40), the power module (10) comprises a housing (11) incorporating at least one electronic chip (14) arranged on a substrate (18); the housing (11) comprises a lower face (12) facing the printed circuit board (40) and an upper face (13), the printed circuit board (40) comprises an upper face (41) on which the power module (10) is mounted and a lower face (42), **characterized in that** the temperature sensor (20, 50) is vertically aligned with the power module (10) between the lower face (12) of the power module (10) and the lower face (42) of the printed circuit board (40), and **in that** the substrate (18) is situated between the electronic chip (14) and the temperature sensor (20, 50).

2. Assembly (100, 200) according to claim 1, **characterized in that** at least two electrical connection pins (15, 16) extend from the housing (11) of the power module (10), these electrical connection pins (15, 16) being in contact with conductive tracks arranged on the printed circuit board (40).

3. Assembly (100) according to claim 1 or 2, **characterized in that** the temperature sensor (20) comprises a housing (21) having a lower face (22) facing the printed circuit board (40) and an upper face (23) facing the power module (10), at least two electrical connection pins (24, 25) extend from the housing (21) of the temperature sensor (20), these electrical connection pins (24, 25) being in contact with conductive tracks arranged on the printed circuit board (40).

4. Assembly (100) according to one of the preceding claims, **characterized in that** a recess (17) is formed in the lower face (12) of the power module (10), and said temperature sensor (20) is partially housed within this recess (17).

5. Assembly (100) according to claim 4, **characterized in that** a thermal interface material (30) is disposed between the power module (10) and the temperature sensor (20).

6. Assembly (200) according to claim 1 or 2, **characterized in that** the temperature sensor (50) is integrated into the printed circuit board (40) between the upper face (41), on which the power module (10) is mounted, and the lower face (42).

7. Assembly (200) according to claim 6, **characterized in that** the printed circuit board (40) is a multilayer board incorporating a plurality of intermediate conductive tracks (43) arranged between the upper face (41) and the lower face (42) of the printed circuit board (40).

8. Assembly (100, 200) according to claim 6 or 7, **characterized in that** a thermal interface material (30) is disposed between the power module (10) and the upper face (41) of the printed circuit board (40).

9. Assembly (100, 200) according to one of the preceding claims, **characterized in that** it further comprises a heat sink, the upper face (13) of the power module (10) being in contact with the heat sink.

10. On-board charger or inverter device for a motor vehicle comprising an assembly (100, 200) according to at least one of the preceding claims.
